# EUROPEAN PATENT SPECIFICATION

(11) **EP 0 482 940 B1**
(45) Date of publication and mention of the grant of the patent: **27.03.1996**
(21) Application number: 91309865.3
(22) Date of filing: 24.10.1991
(51) Int. Cl.: H01L 21/60, H01L 23/498

(54) **Method of forming an electrical connection for an integrated circuit**
Verfahren zur Herstellung einer elektrischen Verbindung für eine integrierte Schaltung
Procédé de fabrication d'une connection électrique pour une puce de circuit intégré

(30) Priority: 24.10.1990 JP 286368/90
(43) Date of publication of application: 29.04.1992
(73) Proprietor: NEC CORPORATION, Tokyo (JP)
(72) Inventor: Mori, Youichi, Minato-ku, Tokyo 108-01 (JP)
(74) Representative: Garratt, Peter Douglas

(56) References cited:
- US-A- 4 772 936
- TOUTE L'ELECTRONIQUE. no. 446, August 1979, PARIS FR pages 25 - 30; M.MONNIER: "Circuiterie sur film polyimide"
- PATENT ABSTRACTS OF JAPAN vol. 9, no. 284 (E-357)(2007) 12 November 1985, & JP- A- 60 126856
- PATENT ABSTRACTS OF JAPAN vol. 6, no. 81 (E-107)(959) 19 May 1982, &JP-A-57 018347

## Description

The invention relates to a method of fabricating a film carrier type semiconductor memory device carried on a tape in the form of film with a lead pattern thereon formed by the printed wiring technique, and having a semiconductor chip attached thereto.

Conventional carrier tapes in the form of film used for semiconductor devices of such type are strip tapes of insulating material such as polyimide, which are each provided with a row of sprocket perforations at fixed intervals along each longitudinal edge. These sprocket perforations are engaged by the sprockets of a tape drive mechanism, which advances the tape a needed distance each time to the position for attaching a semiconductor chip thereto. The tape further is provided with rectangular or square openings, the so called device holes, in the longitudinal center zone thereof, and an elongated opening, the so called outlead hole, alongside of each edge of each device hole, totally 4 openings. Thus suspenders are formed between the device hole and the associated outlead holes. The lead pattern on the tape which is formed by the printed wiring technique comprises a number of leads consisting of inner leads projecting like the fingers into the device hole and outer leads flaring in the suspender areas, crossing the outlead holes, and ending at pads with which probes are brought into contact when the semiconductor chip is checked for electrical characteristics.

On the other hand, the semiconductor chip to be attached to the carrier tape is provided thereon with electrode terminals on each of which bumps of a metal such as Au are formed (see for example US-A-4.772.936). After alignment of the chip with the device hole, the inner leads extending as the fingers into the device hole are simultaneously connected to the bumps by bonding under heat and pressure or with eutectic formation (Inner lead bonding). It is usual that for the former, the end portions of the inner leads and the bumps are previously plated with Au, and for the latter the bumps are made of Au and the leads are plated with Sn.

After this inner lead bonding, the upper surface of the semiconductor chip is covered with a resin in order to improve the mechanical strength of the above-mentioned connections and moisture-proofness as desired. After these processing steps, the electrical characteristics of the semiconductor chip are checked through the intervention by probes brought into contact with the pads.

In the process of attaching this film carrier type semiconductor device to a printed circuit board, as will be described under, first the leads are cut into desired lengths in position within the above-mentioned four elongated opening to separate the semiconductor chip from the carrier tape. Subsequently the undersurface of this semiconductor chip is adhered with an adhesive, and those leads extending outwards in relation to the semiconductor chip are simultaneously pressed to be bonded to bonding pads on a printed circuit board (outer lead bonding).

As apparent from the above description, the film carrier type semiconductor device has advantage that simultaneous bonding of leads connected to the chip is possible even if the number of them is large, which leads easily to reduction of working time and automation. It however is needed to form bumps of Au on the electrode terminals of the chip, reflecting much cost for both material and process. Thus this type of semiconductor devices can be fabricated at uncreased fabrication costs (Japanese Publication Patent Specification No. Sho. 62-31819).

A bump-forming process proposed to solve this problem, which involves carrier tape with bumps (B tape) (Ref.: Solid State technology (Japanese Version), November (1978)) comprises forming projections as bumps electrodes by selectively etching the ends of leads extending on the surface of the carrier tape as film and into the device hole. For obtaining this carrier tape however it is needed to perform metal foil etching for forming the lead pattern and selective etching of the undersurface to form the projections. This does not allow combined use of carrier film tape and metal foil, which restricts to the use metal foil only. The resulting possible troubles in checking electrical characteristics, and the thus-complicated etching process reflects increased fabrication cost compared with the above-stated carrier tape type semiconductor device.

Another example of bump-formed process in the prior art involving bump transfer (Ref.: National Technical Report vol. 31, No. 3, (June, 1985)) which comprises previously forming bumps as of Au on a substrate as of glass by electroplating technique, aligning these bumps with the leads on the carrier tape as film, bonding them all at once to transfer the Au bumps from the glass substrate to the leads. This process comprises the electroplating for forming bumps and the bonding for transferring the bumps to the leads, and therefore is higher in fabrication cost than the above-stated B tape process.

Further example of bump-forming process involves the using as bumps metal ball as of Au (ball bump) formed in wire bonding under heat and pressure (Ref: Japanese Patent Laid-Open Application Specification No. Sho. 60-19545). In this process, after forming ball bumps on the electrode terminals of the semiconductor chip, the ball bumps and the leads of the carrier tape are bonded together also under heat and pressure. Since subjected to both processing steps under heat and pressure, as mentioned above, the electrode terminals are liable to be damaged due to the thermal and mechanical stresses. As described above, these bump-forming processes do not achieve a reduction in fabrication cost without lowering the reliability of the semiconductor device.

Toute L'electronique no. 446 8/9/1979 page 25-30 and JP 57-18347 disclose methods of fabricating film carrier tape semiconductor devices in which solder balls are molten to connect the electrodes of the device to the printed circuit board.

It is an object of the present invention to provide a method of fabricating a film carrier type semiconductor device capable of achieving the connection between leads formed on a carrier tape in the form of film and a semiconductor chip without needing Au bumps.

Another object of the present invention is to provide a method of fabricating a carrier tape type semiconductor device at a decreased cost resulting from omitting the Au-bump forming process.

According to the invention there is provided a method of fabricating a film carrier tape semiconductor device comprising the steps of:
providing an insulating film carrier tape with a plurality of leads formed on said insulating film, each of said leads consisting of an inner lead portion and an outer lead portion, a plurality of through holes each provided in an end of a said inner lead, and a tubular conductor layer on the wall of each through hole in contact with said inner lead portion;
assembling said carrier tape with a semiconductor chip having thereon a plurality of electrode terminals such that each of the electrode terminals of said semiconductor chip is aligned with an associated one of said through holes of said carrier tape; and characterised by
providing solder in the form of a paste in each of said through holes before assembling the carrier tape with the semiconductor chip; and
reflowing the solder in said through holes thereby to connect each of said electrode terminals of said semiconductor chip to the conductor layer in the associated through hole.

In a preferred method each of said electrode terminals of said semiconductor chip is coated with a barrier layer.

The solder bump may be formed on a barrier layer.

The solder paste may be disposed in the through holes by screen printing.

Reference will now be made, by way of example, to the accompanying drawings, in which:-
Fig. 1 is a plan view of a device fabricated by the present invention;
Fig. 2 is a cross-sectional view along line A-A of Fig. 1;
Figs. 3(a) and 3(b) are cross-sectional views illustrating stepwise a process for fabricating the device;
Figs. 4(a) and 4(b) are cross-sectional views illustrating stepwise a modified process;
Fig. 5 is a cross-sectional view illustrating the film carrier type semiconductor device mounted on a printed circuit board.

A preferred embodiment of the present invention will be described with reference to the drawings hereinafter:

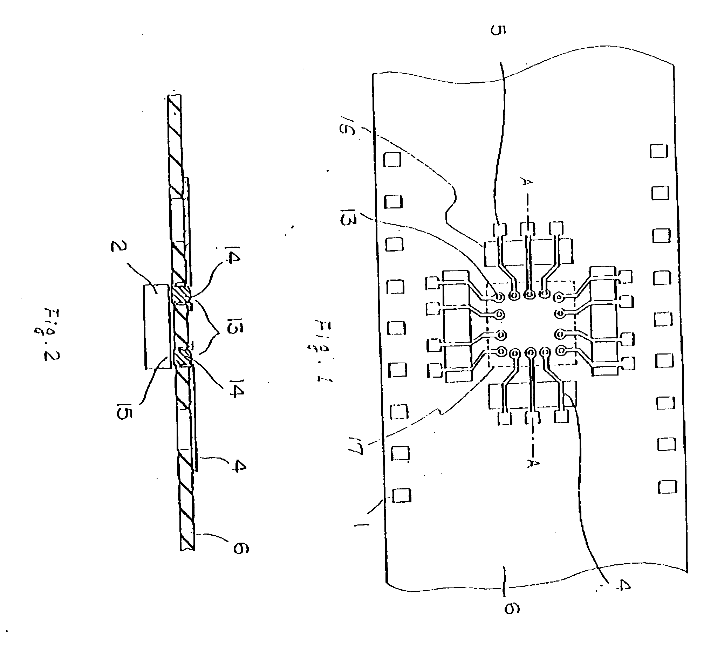

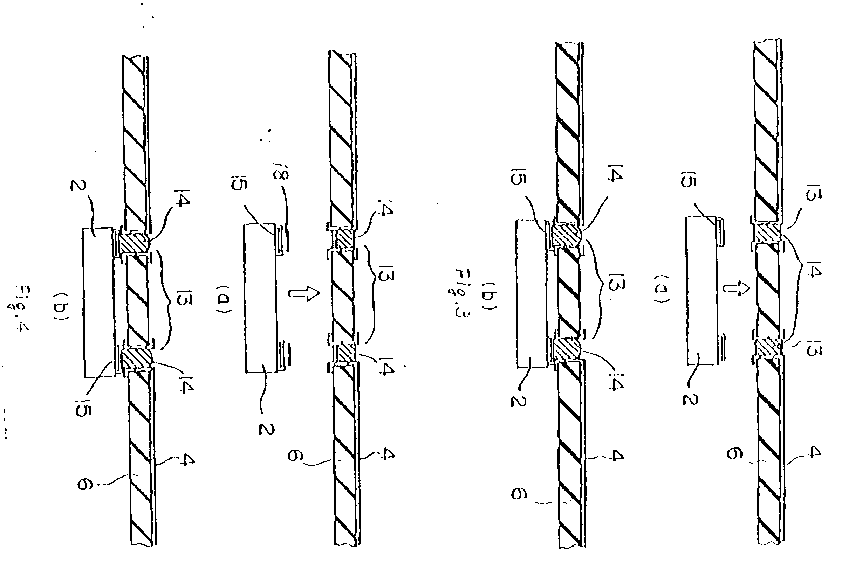

In Figs. 1 and 2 a reference numeral 6 designates a tape of film made of an insulating material such as polyimide, which is provided with a row of sprocket holes 1 at fixed intervals along each edge of it. The sprocket holes 1 are engaged by teeth of a drive mechanism (not shown) by which the tape 6 is driven lengthwise. In the center area with the widthwise relation of the tape a semiconductor chip area 17 is defined by a dash line where a semiconductor chip 2 is to be attached, and there are provided a rectangular opening 16, totally four openings outwardly along each edge of this chip area 17. The tape carries a number of leads 4 formed from the copper foil put thereon by selective etch. One end portions of the leads extend into the semiconductor chip area 17 as fingers, and the other end portions extend away from the semiconductor chip area 17 radially and then cross the four openings 16, respectively.

There are provided a number of through holes 13 inwardly along each edge of the chip area 17 corresponding in location to, and substantially identical in diameter with, the electrode terminals 15 of the semiconductor chip 2. The ends of the leads 4 extending as fingers rest on the upper ends of these through holes. The through holes 13 are formed by mechanical cutting and 100 to 125 µm in diameter. Coating with photoresist, selective exposure, and selective removing of the through hole portions of the photoresist film are performed in sequence. Thereafter Au is evaporated over the hollow cylindrical inner surface of each through hole, and Au plating is applied over the resultant Au layer to form a hollow cylindrical conductor layer lining the through holes 13. The hollow cylindrical conductor layer is electrically connected to leads 4 at the opening of the through holes 13. Subsequently selective application of solder paste to the through holes 13 is carried out by the screen printing technique to fill the through holes 13 with solder 14.

The outer portions of the leads 4 end at test pads 5 with which probes of a measuring instrument are to be brought into contact. On the other hand the semiconductor chip 2 is provided with aluminum electrode terminals 15 on the upper surface thereof, which corresponds in location to the inner ends of the leads 4, and each is connected to the corresponding lead 4 via a barrier layer (not shown) placed between them through intervention by the solder 14.

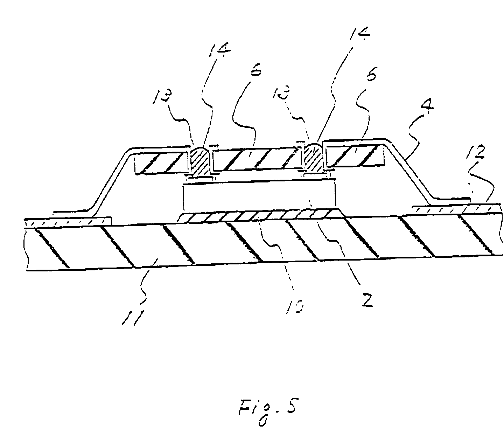

Now, a process for fabricating this device will be described with reference to Figs. 3(a) and 3(b): A number of through holes 13, and hollow cylindrical conductor layers each lining each through hole are formed, and the lined through holes are filled with solder 14, as described above. Thereafter each through hole 13 and the corresponding electrode terminal 15 are aligned with each other, and pressed together. For this alignment, an autoaligning unit comprising a usual pattern recognizer can be used. While remaining pressed together as stated above, solder 14 is heated with an infrared lamp, thereby solder 14 melts partially, resulting in temporary connection of each lead 4 to the corresponding electrode terminal 15 on the chip.

The resulting couple of chip and tape interconnected temporarily is delivered into a reflow furnace, and the solder 14 is caused to melt to complete the connection between the leads 4 and the electrodes 15. In this embodiment, for stronger bonding between the solder 14 and the electrode terminal 15, there is formed a barrier layer as of Ti, Pt or Au and having a thickness of about 0.2 to 0.3 um on the surface of the electrode terminal 15 by plating. Besides for higher efficiency soldering, solder bumps 18 may be formed on the surface of each electrode terminals 15 before the introduction into the reflow furnace (Figs. 4(a) and 4(b)).

After these processing steps of connecting a number of electrode terminals on the semiconductor chip 2 to the corresponding leads 4, tests for the electrical characteristics via the test pads 5 are carried out, and thereafter the semiconductor chip 2 is separated from the tape 6 by cutting the leads 4 in position within the aforesaid rectangular openings 16.

Referring to Fig. 5, the chip 2 carrying leads 4 separated from the tape 6 is fixed to a printed circuit board 11 with an adhesive 10. Then the leads 4 are folded as desired and all simultaneously connected to the corresponding bonding pads 12 of the printed circuit board 11 by the outer lead bonding.

As apparent from the above-described description, the present invention has the feature that the electrical connection between each electrode terminal 15 of the semiconductor chip 2 and the corresponding lead 4 of the tape 6 is made through the intervention by the hollow cylindrical conductor layer lining the corresponding through hole 13 in the tape 6 and the solder 14 filling it. Accordingly the process for forming bumps involving the prior art, for example, that dispensable for the fabrication of tape carrier type semiconductor devices, electroplating for forming bumps, or that for bonding under heat and pressure or by the eutectic indispensable for the inner lead bonding, becomes needless. This enables the film carrier type semiconductor to be fabricated at reduced cost. In addition, in the process according to the present invention, the semiconductor chip 2 is not subject to heating except the period of keeping solder 14 molten, and the mechanical pressure during this period is very limitative, and thus the thermal and mechanical stresses can be greatly reduced, contributing to improvement in the reliability of products.

## Claims

1. A method of fabricating a film carrier tape semiconductor device comprising the steps of:
providing an insulating film carrier tape (6), with a plurality of leads (4) formed on said insulating tape, each of said leads consisting of an inner lead portion and an outer lead portion, a plurality of through holes (13) each provided in an end of a said inner lead, and a tubular conductor layer on the wall of each through hole in contact with said inner lead portion;
assembling said carrier tape with a semiconductor chip (2) having thereon a plurality of electrode terminals (15) such that each of the electrode terminals of said semiconductor chip is aligned with an associated one of said through holes of said carrier tape; and characterised by
providing solder (14) in the form of a paste in each of said through holes before assembling the carrier tape with the semiconductor chip; and
reflowing the solder in said through holes thereby to connect each of said electrode terminals (15) of said semiconductor chip to the conductor layer in the associated through hole.

2. The method as claimed in Claim 1, wherein each of said electrode terminals of said semiconductor chip is coated with a barrier layer.

3. The method as claimed in Claim 2, wherein a solder bump is formed on said barrier layer.

4. The method as claimed in Claim 1-3, wherein the solder paste is disposed in the through holes by screen printing.

## Patentansprüche

1. Verfahren zum Herstellen einer Halbleitervorrichtung vom Filmträgertyp, das die Schritte aufweist:
ein isolierendes Filmträgerband (6) mit einer Vielzahl von Zuleitungen (4), die auf dem isolierenden Band ausgebildet sind, wobei jede der Zuleitungen aus einem inneren Zuleitungsteil und einem äußeren Zuleitungsteil besteht, mit einer Vielzahl von Durchgangslöchern (13), die jeweils in einem Ende einer inneren Zuleitung vorgesehen sind, und mit einer röhrenförmigen Leiterschicht an der Wand jedes Durchgangslochs in Berührung mit dem inneren Zuleitungsteil zu schaffen;
das Trägerband mit einem Halbleiterchip (2) zusammenzusetzen, der auf sich eine Vielzahl von Elektrodenanschlüssen (15) besitzt, so daß jeder der Elektrodenanschlüsse des Halbleiterchips mit einem damit verknüpften der Durchgangslöcher des Trägerbandes ausgerichtet ist, und das dadurch gekennzeichnet ist;
daß Lötmittel (14) in Form einer Paste in jedem der Durchgangslöcher vor dem Zusammensetzen des Trägerbandes mit dem Halbleiterchip vorgesehen wird; und
daß das Lötmittel in den Durchgangslöchern aufgeschmolzen wird, um damit jeden der Elektrodenanschlüsse (15) des Halbleiterchips mit der Halbleiterschicht im damit verknüpften Durchgangsloch zu verbinden.

2. Verfahren nach Anspruch 1, bei dem jeder der Elektrodenanschlüsse des Halbleiterchips mit einer Sperrschicht bedeckt wird.

3. Verfahren nach Anspruch 2, bei dem ein Lötmittelhöcker auf der Sperrschicht ausgebildet wird.

4. Verfahren nach einem der Ansprüche 1 bis 3, bei dem die Lötmittelpaste in den Durchgangslöchern durch Siebdrucken angeordnet wird.

## Revendications

1. Procédé de fabrication d'un dispositif à semiconducteur à bande porte-puces, comprenant les étapes de :
fourniture d'une bande porte-puces isolante (6) avec une pluralité de conducteurs (4) formés sur ladite bande isolante, chacun desdites conducteurs étant constitué d'une partie de conducteur intérieure et d'une partie de conducteur extérieure, une pluralité de trous traversants (13) chacun réalisé dans une extrémité dudit conducteur intérieur, et une couche conductrice tubulaire sur la paroi de chaque trou traversant en contact avec ladite partie de conducteur intérieure;
assemblage de ladite bande porte-puces avec une puce de semiconducteur (2) ayant sur elle une pluralité de bornes d'électrodes (15) de façon que chacune des bornes d'électrodes de ladite puce de semiconducteur soit alignée avec l'un associé desdits trous traversants de ladite bande porte-puces, et caractérisé par:
l'application de soudure (14) sous la forme d'une pâte dans chacun desdits trous traversants avant l'assemblage de la bande porte-puces avec la puce de semiconducteur; et
la refusion de la soudure dans lesdits trous traversants afin de connecter ainsi chacune desdites bornes d'électrodes (15) de ladite puce de semiconducteur à la couche conductrice dans le trou traversant associé.

2. Procédé selon la revendication 1, dans lequel chacune desdites bornes d'électrodes de ladite puce à semiconducteur est revêtue d'une couche d'arrêt.

3. Procédé selon la revendication 2, dans lequel une bosse de soudure est formée sur ladite couche d'arrêt.

4. Procédé selon les revendications 1-3, dans lequel la pâte de soudure est disposée dans les trous traversants par sérigraphie.
